# EUROPEAN PATENT APPLICATION

(11) **EP 1 244 221 A1**
(43) Date of publication of application: **25.09.2002**
(21) Application number: 01106459.9
(22) Date of filing: 23.03.2001
(51) Int. Cl.: H03M 7/30

(54) **Method and system for eliminating data redundancies**

(71) Applicant: SUN MICROSYSTEMS, INC., Mountain View, California 94043-1100 (US)
(72) Inventor: Krapp, Oliver, 20255 Hamburg (DE); Laux, Thorsten O., 20099 Hamburg (DE); Heilig, Jörg, 22145 Hamburg (DE)
(74) Representative: HOFFMANN - EITLE

(57) **Abstract**

Method and system for eliminating data redundancies for example in a memory storing a large number of data blocks. In order to determine whether a data block is redundant or not, a data block identifier is calculated based on the data block and compared to a data block identifiers of data blocks already available or registered. If a data block identifier corresponding to the newly determined data block identifier is available, the corresponding data block is registered as being redundant, e.g. the corresponding data block is deleted from a storage device or replaced by a link to another memory location. If a corresponding data block identifier does not exist, the data block is registered as being not redundant, which may include allocating memory space on a data carrier.

## Description

### Field of the Invention

The present invention relates to a method and system for eliminating data redundancies, e.g. in a computer memory, on a data carrier or similar.

### Background Art

Computers and networks of computers provide services in a growing number of fields, including office applications such as text processing or spread sheet applications, e-mail applications, virtual shopping services, home banking applications, personal service applications or applications in connection with an operating system.

These applications generally provide services to a user operating a data processing device, and to do so, these applications may either be directly executed at the user's data processing device or may be executed at a remote data processing device or server, e.g. under control of the user operating a client data processing device.

A data processing device generally includes a central data processing unit for executing coded program instructions of an application. Further, a data processing device generally includes a random access memory for short time storage and a long term memory such as a hard disk, a compact disc or similar. Normally, during executing the coded instructions of an application or program, the central data processing unit allocates storage space in the long term memory or temporary storage space in a random access memory, e.g. for intermediately storing data blocks or partitions of the application program, data to be operated on and similar.

An application may be constituted by a single program to be executed on a single central processing device, making the data processing device to execute corresponding instructions coded in the program. However, with a growing number of applications becoming ever more complex, it may be advantageous to divide applications into a plurality of modules, the application modules cooperating in providing a service to a user. For example, an application relating to an office application such as text processing, could include a plurality of application modules covering the functionality of retrieving a document, displaying a document, receiving and processing editing commands and similar.

If the application program comprises a plurality of application modules, each of the application modules may be authorized to allocate memory partitions in the memories in the process of providing a service to the user.

As applications or application modules may execute similar functionality and/or access similar data to be operated on, different applications or application modules allocate space in commonly accessible memories, e.g., a hard disc, RAM, etc., for the same data or data blocks, the data block for example including data to be operated on, computational results or similar.

Further, particularly in computer networks a large number of users may access computational resources of a server, e.g. through a client unit connecting to the server via a communication link, and a situation may occur wherein a plurality of users launch the same application program for execution at the server unit. In this case the server unit will execute similar processes for the plurality of users and also allocate memory space for example in a random access memory or on storage means such as a hard disk or a writeable compact disc , for identical data or data blocks.

Consequently, in the above cases memory space may be allocated a plurality of times for the same data block.

As a straightforward approach, if the data blocks for example are constituted by data files having names, multiple storage of data files having the same name, e.g. on a hard disk of a home computer, could be avoided by determining data files having the same name and by eliminating all but one data file having the same name.

However, this approach is insufficient as only entire files may be treated and names may be not unique and/or full knowledge of all allocated memory partitions is not available.

### Summary of the Invention

It is therefore desirable to provide a method and system for eliminating data redundancies in a memory of a data processing device or a plurality of data processing devices.

According to one embodiment a method for eliminating data redundancies comprises obtaining a first data block identifier for a first data block, the first data block identifier being calculated based on the data of the first data block; determining whether a second data block identifier matching the first data block identifier is available, the second data block identifier being calculated based on the data of the second data block; and registering the first data block in accordance with the determination result.

Accordingly, the invention advantageously allows to identify data blocks which are already available based on data block identifiers calculated based on the data of the respective data block. In accordance with the determination result, the data block may then be registered, e.g., allowing to avoid multiple allocations of memory space for the same data block and similar.

Advantageously, the first data block identifier may be added to a list of data block identifiers, in case the second data block identifier is not available. Thus, the invention advantageously allows to include a data block identifier of a data block not yet available into the list of data block identifiers. Subsequent operations may then consider the availability of the newly available data block.

Further, adding the first data block identifier to the list of data block identifiers may include storing an address of the first data block in association with the first data block identifier. This facilitates obtaining a data block in correspondence to a data block identifier.

In case the second data block identifier is available at the determining means, the registering operation of the first data block may include one of the group consisting of: - deleting the first data block from a storage means; and - replacing the first data block in a storage means by a link to the second data block. Thus, if a data block is already available, the data block is a redundant data block and may be removed, freeing storage space in the storage means. Further, in order to allow a program to still access information of, e.g., the redundant first data block which is removed, the first data block may be replaced by a link to the second data block, i.e. the data block associated with the data block identifier already listed in the list of data block identifiers. This may for example be achieved by transmitting an address of the second data block stored in association with the data block identifier of the second data block.

Further, registering the first data block, in case the second data block identifier is not available, may include at least one of the group consisting of: - storing the first data block on a data carrier; and - transmitting the first data block to a receiving unit. Therefore, for example during preparation of a collection of data blocks, e.g. for storage on a compact disc or similar, the first data block, which was determined not to be available yet, can be stored on the data carrier, or may be transmitted to a receiving unit, for example over a network or similar.

Still further, a memory allocation request for the first data block may be received from a process, and the registering of the first data block may include, in case the second data block identifier is available, generating and transmitting a link to the data block to the process; and wherein registering the first data block may include, in case the second data block identifier is not available, transmitting an allocation instruction to the process to instruct the process to allocate storage space for the first data block, and receiving an address of the allocated storage space and including the address into the list of data block identifiers. Thus, for example in case of a distributed system a process which wants to allocate memory space for a data block, may advantageously transmit an allocation request in order to effect a determination operation whether the data block is already available, i.e. memory is already allocated for the corresponding data block. If memory is available, the process may only receive a link to the data block to further use this link in operations, the link preferably pointing to the requested data block. Only if the data block is not already available, i.e. allocated, the process may receive an allocation instruction and proceed to allocate memory space for the data block. In turn, in order to allow a proper registration of the data block, the process may then return an address to the allocated storage space for inclusion into the list of data block identifiers in association with the corresponding data block identifier.

The first and second data block identifiers may be constituted by checksums.

Further, if the second data block identifier is available, a second data block associated with the second data block identifier may be retrieved and a processing operation may be performed for determining whether the first data block and the second data block correspond to one another. Thus, in the unlikely event that two data block identifiers are identical, while the corresponding data blocks are not, a further operation may be performed in order to avoid erroneous registration results.

This processing operation may advantageously include at least one of the group consisting of: - obtaining detailed data block identifiers of the first data block and the second data block having more bits than the first and second data block identifier; - comparing the bits of the first data block and the second data block. Thus, a multi-layered data block identifier computation may be performed, wherein initial data block identifier computation can be fast, and only if an equality of two data block identifiers is determined, a more detailed data block identifier can be computed. Further, it is also possible to directly compare the data blocks on a bit by bit basis in order to determine a quality.

Further, the processing operation may include at least one of: data block names of the first and second data block; - dates indicating a time of creation of the first and second data block; and - dates indicating a time of alteration of the first and second data block.

According to another embodiment a method for avoiding data redundancies at a data processing unit may include obtaining a first data block identifier for a first data block, the first data block identifier being calculated based on the data of the first data block; generating a memory allocation request for the first data block at the data processing unit; transmitting the memory allocation request to a redundancy handler, instructing the redundancy handler to determine whether a second data block identifier matching the first data block identifier is available in a list of data block identifiers, wherein the second data block identifier is calculated based on the data of the second data block; and receiving an allocation response at least indicating whether the second data block identifier of the second data block is available.

Thus, if a plurality of processes employs the allocation operations as above, multiple memory allocations for the same data block may be avoided.

Advantageously, the allocation request may include at least one of an address of the first data block and the first data block identifier, and, in case the second data block identifier is available, the allocation response may include a link to the second data block and the data processing unit may use the link to the second data block to access the second data block. Thus, instead of allocating memory for the data block, the process may use a link to a memory space already allocated instead.

Further, in case the second data block identifier is not available, the allocation response may include an allocation instruction to allocate storage space for the first data block, and to transmit an address of the allocated storage space to the redundancy handler, instructing the redundancy handler to store the address of the first data block in association with the first data block identifier. This provides for maintaining an up-to-date list of data block identifiers in correspondence to data blocks, such that a newly allocated memory space for a data block may be appropriately considered.

Further, a program may include instructions adapted to carry out one or a plurality of the above operations. A computer readable medium may be provided, in which a program is embodied, where the program is to make a computer execute one or a plurality of the above operations. A computer program product may comprise the computer readable medium.

According to another example an apparatus for eliminating data redundancies may comprise an identifier obtaining unit to obtain a first data block identifier for a first data block, the first data block identifier being calculated based on the data of the first data block; a determining unit to determine whether a second data block identifier matching the first data block identifier is available in a list of data block identifiers including a plurality of data block identifiers, the second data block identifier being calculated based on the data of the second data block; and a registering unit to register the first data block in accordance with the determination result.

According to another example a data processing unit for avoiding data redundancies may be adapted to obtain a first data block identifier for a first data block, the first data block identifier being calculated based on the data of the first data block; generate a memory allocation request for the first data block; transmit the memory allocation request to a redundancy handler, instructing the redundancy handler to determine whether a second data block identifier for a second data block matching the first data block identifier is available, the second data block identifier being calculated based on the data of the second data block; and

Further advantageous features of the invention are disclosed in further claims.

### Brief Description of the Drawings

The invention may be fully appreciated if the following detailed embodiments are taken in conjunction with the accompanying drawings:
- Fig. 1: shows a device for reducing redundancies according to an embodiment of the invention;
- Fig. 2a: shows operations of a method for eliminating data redundancies according to an embodiment of the invention;
- Fig. 2b: shows operations of a method for eliminating data redundancies according to an embodiment of the invention;
- Fig. 3: shows an apparatus for eliminating data redundancies according to another embodiment of the invention;
- Fig. 4: shows operations of a method for eliminating data redundancies according to another embodiment of the invention;
- Fig. 5: shows operations of a method for eliminating data redundancies according to another embodiment of the invention;
- Fig. 6: shows operations of a method for eliminating data redundancies according to another embodiment of the invention;
- Fig. 7: shows elements of a system for eliminating data redundancies according to another embodiment of the invention; and
- Fig. 8: shows operations of a method including a process and a redundancy handler for eliminating data redundancies according to another embodiment of the invention.

In the figures alike reference numerals denote alike elements. Further, the first digit of a reference numeral indicates the figure in which the respective element occurred for the first time.

### Detailed Description of the Preferred Embodiments

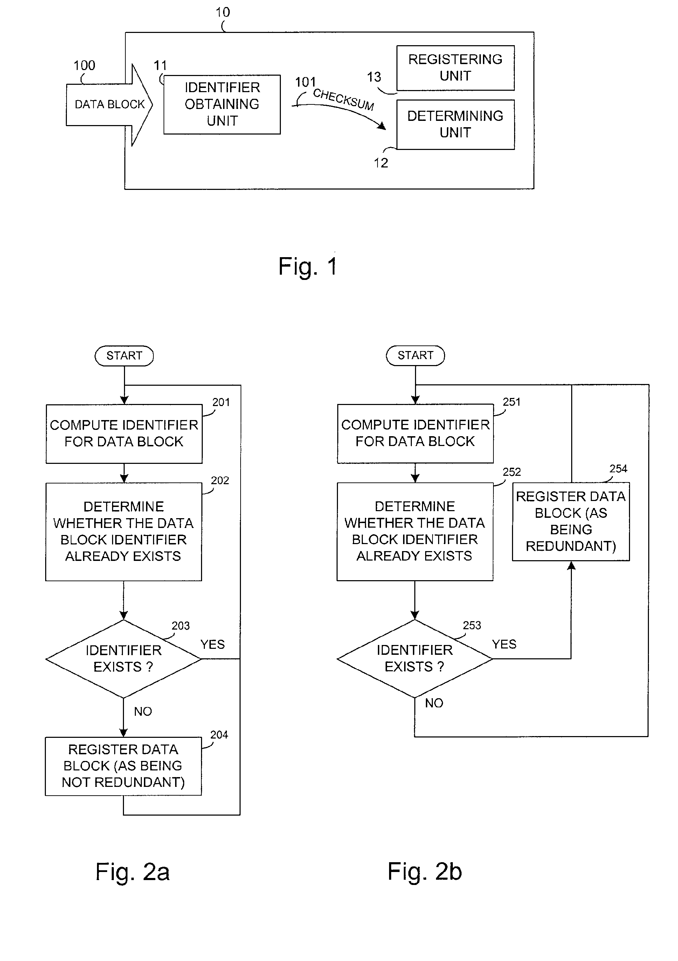

Fig. 1 shows an apparatus for eliminating data redundancies according to an embodiment of the invention. The apparatus for eliminating data redundancies is generally indicated at a reference numeral 10. The device 10 includes a identifier obtaining unit 11, a determining unit 12, and a registering unit 13.

The identifier obtaining unit 11 is arranged to obtain, e.g., from external means, or to calculate a data block identifier for a current data block, the data block identifier being calculated based on the data of the data block. The data block may be received at the identifier obtaining unit 11 from an arbitrary source, as indicated by an arrow 100. The identifier obtaining unit transmits the data block identifier, as indicated by an arrow 101, to the determining unit 12.

The determining unit is arranged to determine whether another data block identifier, associated with another data block and calculated based on the data of this other data block, matching the transmitted data block identifier, is available.

For the determining operation the determining unit may obtain information from a list of data block identifiers in preparation of performing the determining operation.

The registering unit 13 then registers the data block in accordance with the determination result received from the determining unit. The registering unit 13 thus treats the data block depending on the determination result. For example, the registering unit could be arranged to mark the data block as being redundant, if it was determined at the determining unit 12 that another data block identifier identical to the data block identifier of the current data block is available. Alternatively, if another data block identifier identical to the data block identifier of the current data block was determined to be not available, the registering unit could mark the current data block as not being redundant.

In dependence on the classification result, i.e., the mark indicating that a data block is redundant or not redundant, a further processing for handling the data block could be performed.

For example, in case another data block identifier corresponding to the current data block identifier is determined to be available, the current data block, i.e. the data block corresponding to the current data block identifier could be deleted from storage means. Further, in this case the current data block could be replaced in the storage means by a link to the data block corresponding to the data block identifier which was identified by the determining unit to correspond to the current data block identifier. Thus, a process, program, application or similar, attempting to access the current data block, could be redirected to another memory location storing information identical to the current data block.

Further, if the determining unit determines that a data block identifier corresponding to the data block identifier transmitted from the identifier obtaining unit 11 is not available, the current data block could be stored on a data carrier, such as a random access memory, a hard disk, a floppy disk, a compact disc or similar. Further, in this case the current data block could be transmitted to a receiving unit (not shown), for example via a communication link, involving a computer network, wireless connections or dedicated communication links.

In the following, the elements of the apparatus for eliminating data redundancies shown in Fig. 1 will be outlined in further detail. It is noted that the following details of the elements constitute examples only, and that the invention is not limited to the exact features given below.

The apparatus for eliminating data redundancies 10 may in general be any kind of dedicated device or distributed device incorporating the elements shown in Fig. 1. For example, the apparatus for eliminating data redundancies 10 could be a general purpose data processing device, such as a home computer, could be a server unit adapted to communicate information with a plurality of client units. The apparatus for eliminating data redundancies could be controlled using software programs or could be constituted by a dedicated hardware arrangement.

Alternatively, it is possible that the apparatus for eliminating data redundancies is constituted by a distributed arrangement of data processing devices incorporating one or more of the elements shown in Fig. 1. The plurality of data processing devices constituting the apparatus for eliminating data redundancies could be connected via internal or external communication links, including communication networks such as local area networks or wide area networks, or dedicated communication links including wireless communications.

The identifier obtaining unit 11 may be constituted by a central data processing unit of the apparatus for eliminating data redundancies 10 or may be constituted by a separate device. The identifier obtaining unit 11 could be controlled via a software program or could be realized as a hardware implementation. Preferably, the identifier obtaining unit is adapted to calculate a large number of data block identifiers in a short period of time, e.g. data block identifiers for data blocks received from one or a plurality of sources.

A data block received at the identifier obtaining unit 11, as indicated by arrow 100, may incorporate any kind of data, such as text information, video information, audio information or other information constituting software programs or similar. Data blocks may have a predetermined length, in which case data files, or data streams may be suitably partitioned into data blocks.

However, it is also possible that the data blocks have variable length, for example if a data block corresponds to a data file, to a software program, a module of a software program, or any other piece of data.

The data blocks may be embodied by a sequence of binary bits, e.g. arranged in information bytes. However, the data blocks do not necessarily have to be embodied as binary information, any other type of representation could be present.

The identifier obtaining unit 11 preferably obtains a data block identifier, preferably a unique data block identifier for the data block received. For example the data block identifier could be retrieved from external means, e.g. a storage means storing a list of data block identifiers, for example in association with respective data blocks.

Alternatively, the identifier obtaining unit 11 may itself determine the data block identifier of the data block, e.g. in a calculation operation based on the data of the data block.

The data block identifier may be a result of a processing operation depending on the information bits or other information elements of the data block.

For example, the data block identifier could be a checksum. A checksum generally is a value used to ensure data is stored or transmitted without error. According to the invention a checksum can be used for identifying a data block. A checksum is normally created by calculating the binary values in a block of data using an algorithm and may be a CRC (cyclical redundancy checking) checksum. CRC is an error checking technique which may be used to ensure the accuracy of transmitted digital information. Transmitted information may be divided into predetermined blocks which, used as dividends, may be divided by a fixed divisor.

However, any other type of data block identifier could be used and, if for example the information is not embodied as digital information, the data block identifier may be constituted by other unique identifier information characterizing the data block, for example a frequency spectrum. In this case, data formats would be suitably converted between digital and analog formats in order to facilitate computing the data block identifier such as a checksum, i.e. the unique information identifying the data block. Further, a hash code, e.g., including words or characters, in connection with a hash table may be employed, or similar.

The data block identifier obtained by the identifier obtaining unit 11 for the received current data block, as indicated by arrow 100, is transmitted to the determining unit 12.

The determining unit may be constituted by a central processing unit of the apparatus for eliminating data redundancies 10, or may be constituted by a separate data processing unit, as appropriate. The determining unit may be controlled by software programs or may be realized as a hardware implementation and is arranged to determine whether a data block identifier matching the current data block identifier is already available. If a data block identifier matching the current data block identifier, received from the identifier obtaining unit 11, is already available at the determining unit, it is indicated that a data block identical to the current data block is already registered, likewise, if a data block identifier matching the current data block identifier cannot be found, it is indicated that the corresponding data block has not been registered before, i.e., the data block is not redundant.

The determining unit 12 may maintain or access information on all data block identifiers of all already registered data blocks, in order to perform the determination operation. The determination operation may involve a comparison operation of the current data block identifier received from the identifier obtaining unit 11 with all data block identifiers already available at the determining unit 12. The determining unit may hold the data block identifiers of all registered data blocks internally, or may be connected to external means maintaining the data block identifiers, e.g., a list of data block identifiers.

A list of data block identifiers may be stored in a storage device of the unit for eliminating data redundancies 10, e.g. a hard disk, a random access memory or similar. It is also possible that a list of data block identifiers is stored in external storage means connected to the determining unit 12.

In this case the determining unit obtains data block identifiers from the list of data block identifiers in order to compare these data block identifiers with the current data block identifier corresponding to the current data block received from the identifier obtaining unit 11.

The determination result indicating whether the current data block identifier received from the identifier obtaining unit 11 is already available at the determining unit, indicating that a data block corresponding to the current data block is already available or not, i.e. is redundant or not redundant, is transmitted from the determining unit 12 to the registering unit 13.

The registering unit 13 may be a central processing unit of the apparatus for eliminating data redundancies 10 or may be a separate unit. The registering unit 13 may be controlled by software programs, or may be realized as a hardware implementation and preferably executes registering operations in dependence on the determination result received from the determining unit. This may for example include simply marking the corresponding data block as being redundant or not redundant, or may involve further handling operations for treating the data block as being redundant or not redundant.

For example, if the data block is determined to be redundant, the registering unit could effect a deletion of the data block from a data carrier such as a hard disk, a random access memory, a floppy disk, a compact disc or similar. Thus, a storage space used for the storage of a number of data blocks could be minimized.

If a plurality of applications already allocated storage space for the same data block, unnecessary copies of the data block could thus be removed. Further, in a collection of large numbers of data blocks, for example program libraries or similar, unnecessary duplicates of a data block could be removed.

Further, an unnecessary duplicate copy of a data block could be replaced by a link to another storage location storing identical information. For example, if a plurality of application programs, modules of application programs or processes individually allocated storage space for identical data blocks and unnecessary duplicate copies of information were removed as outlined above, runtime errors during memory accesses could result. However, if deleted copies of data are replaced by links, and processes attempt to access the data block for processing operations, runtime errors can be avoided, since a process, trying to access a removed copy of the data block, could be redirected to another location storing the data block.

Likewise, if the determination result indicates that the data block is not redundant, i.e. was not registered before, the registering unit could effect storing the data block on a data carrier, e.g., effect the allocation of storage space on a data carrier. For example, if a program library is to be stored on a data carrier such as in a random access memory, on a hard disk, compact disc or similar, memory space would only be allocated for data blocks which are not redundant.

The same considerations apply, if a plurality of application programs or program modules attempt to allocate memory for the same data block. Only if the data block is not redundant and thus not already available, the application program or application module may be authorized to allocate memory on the data carrier. If the data block were already available, the application program or application module could instead be provided with a link to another memory location storing the data block.

Further, if the data block is not redundant, the registering unit could also transmit the data block to a receiving unit, e.g. via a network or dedicated communication links including wireless transmissions. For example, if a collection of data blocks is to be transmitted from a server unit to a client unit, only not redundant data blocks could be transmitted to the client unit for further processing.

Thus, the invention advantageously allows to eliminate data redundancies in a plurality of data blocks by determining data block identifiers for each data block to be registered and by determining whether a corresponding data block identifier is already available. If such a data block identifier is not available, the data block may be registered as not redundant, if such a data block identifier is available, the data block may be registered as redundant, involving suitable handling of the data block, for example deletion, replacement and similar.

It is also possible that upon a determination result that the data block is redundant, information specifying the redundant data block is stored in a list of redundant data blocks.

In the following a further embodiment of the invention will be described with respect to Fig. 2a.

Fig. 2a illustrates operations of a method for eliminating data redundancies according to another embodiment of the invention. The operations of Fig. 2a may be carried out using the apparatus shown in Fig. 1, however, Fig. 2a is not limited thereto.

In an operation 201, e.g. executed at the identifier obtaining unit 11 shown in Fig. 1, a data block identifier for a data block is obtained by retrieving it from an external source or by calculating it. Operations for obtaining the data block identifier may be as outlined with respect to the embodiment described with respect to Fig. 1.

In an operation 202 it is then determined whether the computed data block identifier already exists, e.g. in a list of data block identifiers. Naturally, the data block identifier computed in operation 201 and the data block identifiers used in the determining operation, e.g. the data block identifiers of the list of data block identifiers of operation 202 will be obtained using the same algorithm.

In an operation 203 it is decided whether the data block identifier exists. If in operation 203 the decision is "NO", indicating that the data block identifier does not exist, in an operation 204 the data block is registered as being not redundant. Registering the data block as being not redundant may include storing the data block on a data carrier or transmitting the data block to a receiving unit, as outlined with respect to Fig. 1.

If in operation 203 the decision is "YES", indicating that a data block identifier corresponding to the data block identifier computed in operation 201 already exists, the flow returns to operation 201 to compute the data block identifier for a next data block.

The sequence of operations of the embodiment shown in Fig. 2a may advantageously be used to generate a collection of not redundant data blocks, e.g. for storage on a data carrier or transmission to a receiving unit. Only if a data block is not redundant, the data block is registered, e.g. stored or similar.

For example if an apparatus for eliminating data redundancies receives a stream of data blocks, including redundant versions of some of the data blocks, the apparatus could be used as a filter which only passes data blocks which were not received and transmitted at an earlier point in time.

In the following a further embodiment of the invention will be described with respect to Fig. 2b.

Fig. 2b illustrates operations of a method for eliminating data redundancies according to another embodiment of the invention. The operations of Fig. 2 may be carried out using the apparatus illustrated in Fig. 1, however, Fig. 2b is not limited thereto.

Similar to Fig. 2a, in a first operation 251 a data block identifier for a data block is obtained, e.g. by the identifier obtaining unit 11 shown in Fig. 1.

In an operation 252, similar to Fig. 2a, it is determined in a list of data block identifiers whether the data block identifier from operation 251 already exists. As before, this may be a determining operation involving a list of data block identifiers of data blocks which were already registered at an earlier point in time. The determination may be carried out as described with respect to Fig. 1.

In operation 253 it is decided whether such a data block identifier already exists.

If in operation 253 the decision is "YES", indicating that the data block identifier of operation 251 already exists, the data block is registered in an operation 254 as being redundant. Registering the data block as being redundant may include deleting the data block from storage means or replacing the data block in storage means by a link to another memory location storing the data block, or may include returning to a requesting unit a link to the other memory location already storing the data block.

If in operation 253 the decision is "NO", indicating that the data block identifier computed in operation 251 did not already exist, the flow returns to operation 251 for computing the data block identifier of the next data block.

While the embodiment of Fig. 2a may suitably be used as a filter for passing only not redundant data blocks, the embodiment of Fig. 2b may advantageously be used to clean up a data carrier such as a hard disk, a compact disc , a random access memory or similar, by removing redundant data blocks and, if necessary, by replacing redundant data blocks by links to other memory locations storing the data block or by returning links to such memory locations. Accordingly, the embodiment of Fig. 2b may be used to reduce memory space needed for a given number of data blocks, e.g. if a plurality of application programs or application modules partially allocated memory space for identical data blocks.

Alternatively, if in operation 253 the decision is "NO", indicating that the data block is not redundant, before returning to operation 251 for a subsequent data block, the current data block could be registered as outlined with respect to operation 204.

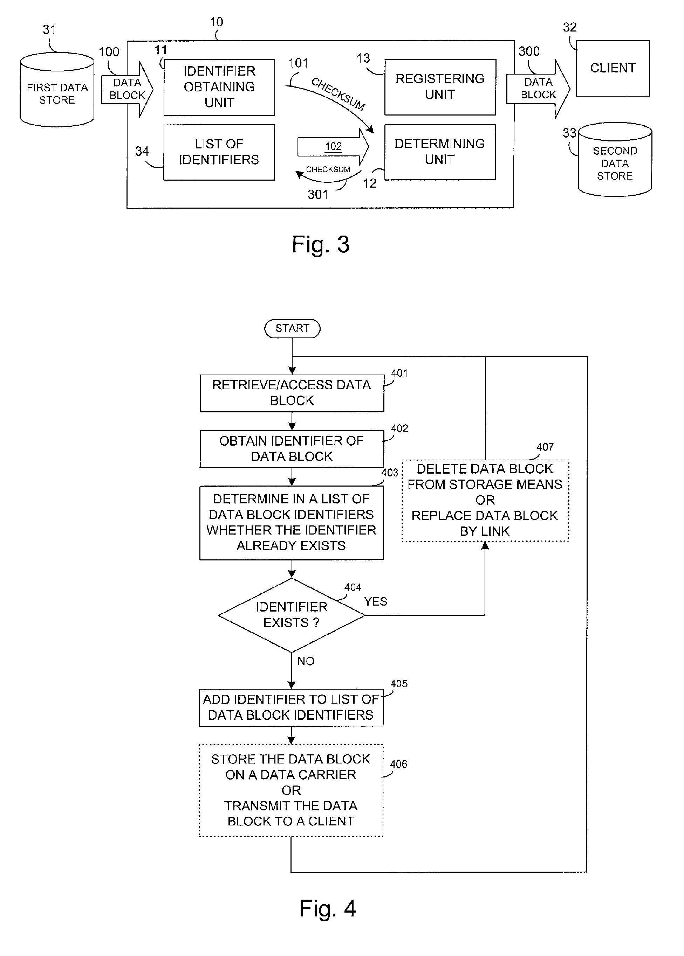

In the following a further embodiment of the invention will be described with respect to Fig. 3.

Fig. 3 illustrates an apparatus for eliminating data redundancies according to another embodiment of the invention.

Fig. 3 illustrates an apparatus for eliminating data redundancies 10, including a identifier obtaining unit 11, a determining unit 12, and a registering unit 13. As these elements may correspond to the elements already described with respect to Fig. 1, a description of these elements is only given in as far these elements differ from the respective elements in Fig. 1.

Further, to the above elements the embodiment of Fig. 3 shows a first data store 31, a client unit 32, a second data store 33 and a list of identifiers 34.

Data blocks may be transmitted from the first data store to the identifier obtaining unit 11 as indicated by an arrow 100.

Further, data blocks for registration may be transmitted from the registering unit 13 to the client unit 32 and/or second data store 33 as indicated by arrow 300.

Further, upon determining at the determining unit 12 that a data block identifier corresponding to the data block identifier received as indicated by arrow 101 from the identifier obtaining unit 11 is not already available, the data block identifier of the data block may advantageously be included into the list of data block identifiers 34, as indicated by an arrow 301.

If the data block identifier determined at the identifier obtaining unit 11 is not already available, determined by the determining unit 12, an address of the data block corresponding to the data block identifier may be stored in association with the data block identifier, e.g. in the list of data block identifiers. Thus, the list of data block identifiers may include a collection of data block identifiers and associated identifiers of data blocks corresponding to the data block identifiers.

Alternatively, the data block identifiers may be stored in association with the data blocks itself.

In the following, examples of the elements shown in Fig. 3, as far as they are not already considered in Fig. 1, will be outlined. It is noted that the below details constitute examples only and do not limit the invention.

The first data store 31 may for example be a data carrier storing a plurality of data blocks. For example, the first data store 31 could be a hard disk of a general purpose data processing device, of a server unit, a client unit or similar. Further, the data store 31 could be a compact disc , a floppy disk or a random access memory.

Similarly, the second data store 33 may be any kind of data carrier, including hard disk, compact disc , floppy disk and random access memory. The second data store 33 may be used to store data blocks which are identified as not being redundant.

The client unit 32 may be a client receiving not redundant data blocks, and may be connected to the second data store 33 for storing the not redundant data blocks. For example, the client unit could be a general purpose data processing device operated by a user who wishes to obtain a collection of data blocks with eliminated redundancies.

The list of data block identifiers 34 may be a collection of data block identifiers and possibly further information associated with data blocks. The list may be stored in data storage means of the apparatus for eliminating data redundancies 10.

The apparatus for eliminating data redundancies 10 shown in Fig. 3 may essentially be used as a filter for transmitting data blocks determined to be not redundant and by retaining, e.g. discarding, data blocks which are determined to be redundant.

However, Fig. 3 is not limited thereto, the apparatus for eliminating data redundancies 10 of Fig. 3 may also be used in a manner as shown in Fig. 1, and described with respect to Fig. 2a and 2b, i.e., may be used to eliminate redundant data blocks from storage means. In this case, the first data store and the second data store could constitute a single unit and the registering unit 13 could effect a deletion of redundant data blocks from the data store or a replacement of a data block by a link, as outlined before. Thus, memory allocated for a plurality of data blocks by a plurality of application programs or application modules, including redundant allocations of data blocks, could be cleaned for reducing a storage amount needed.

Further, the embodiment of Fig. 3 may be used to maintain an up-to-date list of data block identifiers corresponding to data blocks which are already registered.

As indicated by an arrow 301 the determining unit may transmit a data block identifier of a data block which is not redundant to the list of data block identifiers for appending the data block identifier to the list. The transmission of the data block identifier as indicated by arrow 301 may also include a transmission of an address, e.g. a pointer, of the data block corresponding to the data block identifier being transmitted. The address may specify a memory location storing information of the data block.

In operation, the identifier obtaining unit 11 receives a data block from the first data store 31 and determines a data block identifier for the data block, e.g. as outlined before. The data block identifier is transmitted to the determining unit 12 as indicated by an arrow 101, where it is determined whether a data block identifier corresponding to the data block identifier determined at the identifier obtaining unit 11 is already available.

If such a data block identifier is not available, the data block identifier and/or an address of a storage location of information corresponding to the data block is transmitted to the list of data block identifiers 34.

Further, the determining unit 12 may instruct the registering unit 13 to register a not redundant data block, as outlined before.

The embodiment described with respect to Fig. 3 particularly allows to maintain an up-to-date collection of data block identifiers corresponding to already registered data blocks, in order to provide a fast registering operation for data blocks while avoiding redundancies.

In the following a further embodiment of the invention will be described with respect to Fig. 4.

Fig. 4 illustrates operations of a method for eliminating data redundancies according to another embodiment of the invention. The operations of Fig. 4 may be carried out using the embodiments illustrated in Figs. 1 or 3, however, Fig. 4 is not limited thereto.

Fig. 4 particularly describes operations for maintaining a list of data block identifiers up to date, in accordance with a determination result indicating that a data block is redundant or not redundant.

In a first operation 401 a data block is retrieved or accessed. For example, the data block may be part of a program or data needed by a process.

In an operation 402 a data block identifier is obtained for the retrieved data block, e.g. by the identifier obtaining unit 11 of Figs. 1 and 3, similar to operations outlined with respect to previous embodiments.

In an operation 403 it is determined in a list of data block identifiers whether the obtained current data block identifier already exists, i.e. whether the data block identifier is already registered. The operation 403 may be similar to corresponding operations outlined with respect to previous embodiments.

In an operation 404 it is decided whether the data block identifier exists. If in operation 404 the decision is "NO", indicating that the data block identifier does not already exist, in an operation 405 the data block identifier is appended to a list of data block identifiers, for example as outlined with respect to Fig. 3.

Further, in an operation 406, which may be optionally provided, as indicated by the dotted line, the first data file may be registered, e.g. stored on a data carrier or transmitted to a client, as outlined with respect to previous embodiments. The operation 406 may thus correspond to registering operations for registering the corresponding data block as being not redundant.

If in operation 404 the decision is "YES", indicating that the data block identifier already exists, i.e. the data block is redundant, the flow may return to operation 401 or, in an optional operation 407, as indicated by the dotted line, the data block may be registered as being redundant, for example including deleting the data block from storage means or replacing the data block by a link, as outlined before.

In the sequence of operations of Fig. 4, none of the operations 406 or 407, or at least one of the operations 406 and 407 is carried out.

It is noted that even while the operations shown in Fig. 4 are illustrated in a particular sequence, this sequence may be varied in further embodiments, for example operations 405 and 406 may be interchanged.

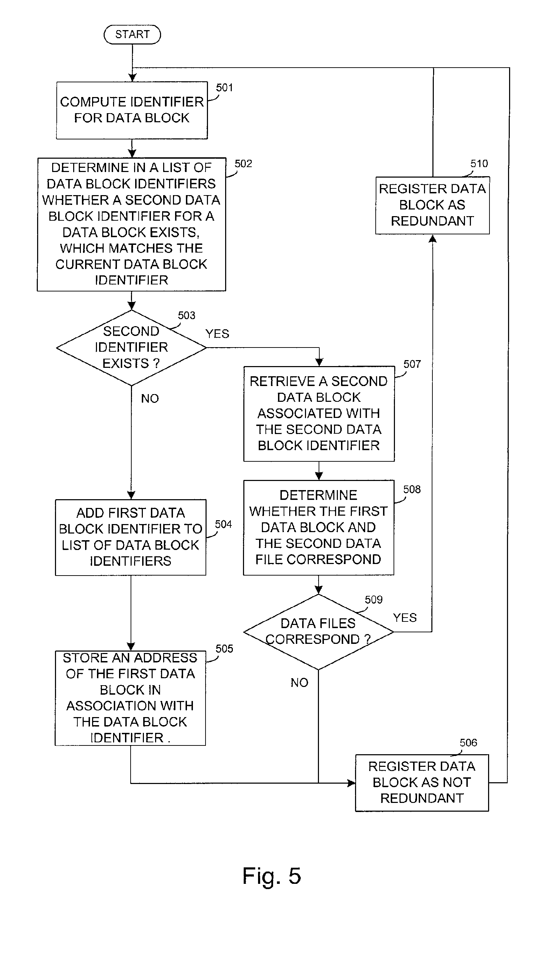

In the following a further embodiment of the invention will be described with respect to Fig. 5.

Fig. 5 shows operations of a method for eliminating data redundancies according to another embodiment of the invention. The operations of Fig. 5 may be carried out using the embodiments shown in Fig. 1 and 3, however, Fig. 5 is not limited thereto.

Fig. 5 particularly outlines operations which may be carried out upon determining that a data block identifier is already available. As a data block identifier may not be unique, it may occur that two data block identifiers are identical, while the corresponding data blocks contain different information.

In this case further processing is necessary in order to determine whether the data blocks indeed contain the same information.

In the embodiment of Fig. 5 in a first operation 501 a data block identifier for a data block is obtained, for example as outlined with respect to previous embodiments.

In an operation 502 it is determined, for example in a list of data block identifiers, whether a second data block identifier for a data block exists which matches the data block identifier computed in operation 501. Operation 502 may be similar to corresponding operations outlined with respect to previous embodiments.

In an operation 503 it is decided whether such a second data block identifier already exists. If in operation 503 the decision is "NO", indicating that the second data block identifier does not exist, in an operation 504 the data block identifier obtained in operation 501 is appended to the list of data block identifiers, e.g. as outlined with respect to Fig. 3.

In an operation 505 an address of the current data block, i.e. the data block considered in operation 501, may be stored in association with the data block identifier added in operation 504. The address may be any information usable to retrieve the corresponding data block, e.g. an address of a storage location or of any other source for providing the data block.

Thus, the data block identifier will include addresses of data blocks in association with the computed data block identifiers, facilitating handling the data block as being redundant or not redundant, e.g. generating and transmitting a link to a data block.

If in operation 503 the decision is "YES", indicating that a data block identifier corresponding to the current data block identifier computed in operation 501 already exists, e.g. in a list of data block identifiers, in an operation 507 the data block corresponding to the data block identifier determined in operation 502, is retrieved. Operation 507 may for example be carried out by using an address of the data block stored in association with the data block identifier in the list of data block identifiers.

In an operation 508 it is then determined whether the information of the data block considered in operation 501 and the data block retrieved in operation 507 indeed correspond to one another.

Thus, the present embodiment provides further security for determining equality of data blocks in cases where data blocks associated with identical data block identifiers should contain different information.

The determining step of operation 508 may include performing any processing operation for determining whether the two data blocks correspond to one another, including for example computing a more detailed data block identifier for the two data blocks, for example data block identifiers having more bits than the initially computed data block identifiers. Thus, it can be conveniently double-checked whether the data blocks are actually identical or not.

In accordance therewith, the first data block identifiers computed could be low level data block identifiers in order to ensure a high throughput of data blocks in registering operations, and only if data block identifiers are determined to correspond to one another, which may be a rare case, further higher level data block identifiers could be computed for making a final decision on equality or inequality of the data blocks.

Of course, further layering of processing operations could be performed, for example in a third data block identifier computation operation could be performed.

Still further, the processing operation could include comparing the considered data blocks on a bit by bit basis, in order to make a final decision on equality of inequality of the two considered data blocks.

Still further, the processing operation of operation 508 may include at least one of comparing data block names of the data blocks, comparing dates indicating a time of creation of the data blocks and/or dates indicating a time of alteration of the data blocks.

Thus, a multi-layered determination operation may be performed for determining whether the data blocks are equal or not.

In an operation 509 it is finally identified whether the data blocks correspond to one another or not. If in operation 509 the decision is "YES", indicating that the data files do correspond, in an operation 510 the data block considered in operation 501 is registered as being redundant, for example as outlined with respect to previous embodiments.

If in operation 509 the decision is "NO", indicating that the data files do not correspond, in an operation 506 the data block considered in operation 501 is registered as not being redundant, for example as outlined with respect to previous embodiments.

Further, in this case any higher level data block identifier may be stored in the list of data block identifiers or in a separate list of data block identifiers for storing higher level data block identifiers. Then, if in operation 503 it is determined that the data block identifier computed in operation 501 already exists, in a further operation the higher level data block identifier could be computed for the data block and compared with the list of higher level data block identifiers.

Thus, the data block identifier computation and comparison operation could be cascaded in a plurality of levels.

The embodiment of Fig. 5 may advantageously be employed in a process where a large number of data blocks is to be stored on a compact disc, or other fixed storage or e.g. on a server unit for download by client units. In this case the redundancy removal operations with the cascaded comparison operation can securely avoid an erroneous elimination of a data block, while saving as much storage space as possible.

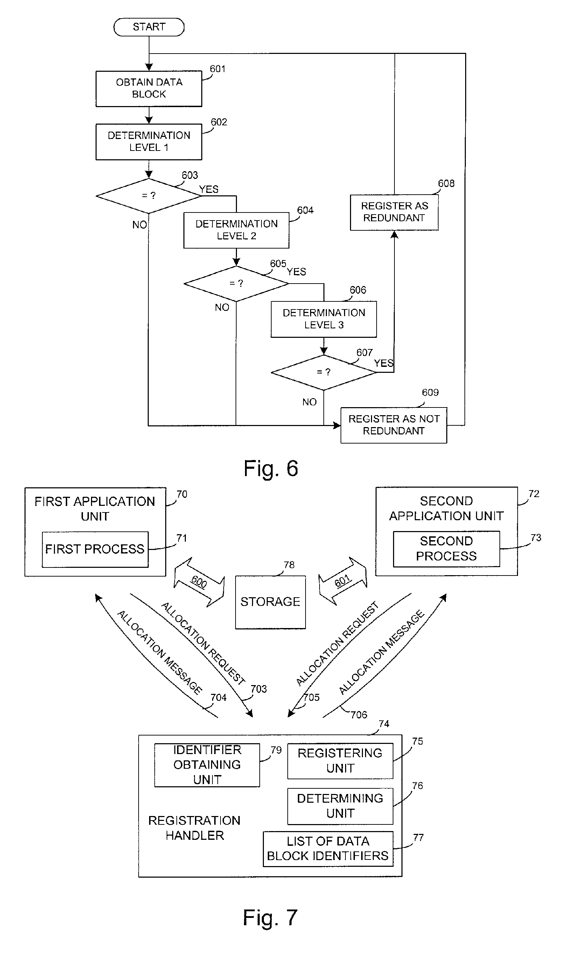

In the following a further embodiment of the invention will be described with respect to Fig. 6.

Fig. 6 shows operations of a method for eliminating data redundancies according to another embodiment of the invention. The operations of Fig. 6 may be carried out using one of the embodiments of Figs. 1 and 3, however, Fig. 6 is not limited thereto.

Fig. 6 further outlines the above described principle of a multi-layered determination for identifying a data block as being redundant or being not redundant. In order to accelerate processing, a first determination level for determining redundancy of a data block may be kept low, e.g. a simple data block identifier could be obtained and compared to a list of data block identifiers or identifiers.

As on the first level the identifier or data block identifier may not be unique, in case a data block is determined to be redundant on this level, a further redundancy check is performed in another layer and, similarly further layers may be provided.

In the embodiment of Fig. 6, in a first operation 601 a first data block is obtained, for example as outlined with respect to previous embodiments.

In a second operation 602 a redundancy determination of a first level is performed, for example as outlined with respect to previous embodiments, particularly Figs. 2a, 2b, 4 and 5. In operation 602 a data block identifier or other identifier of the data block could be obtained and it could be determined whether such an identifier or data block identifier already exists in a list of data block identifiers. As on this level all data blocks must be considered, the first level data block identifiers could be relatively simple in order to reduce a processing time needed for the redundancy check.

In an operation 603 it is decided whether such an data block identifier for the data block already exists.

Since the complexity of the first determination level is preferably fairly low, it may not be assured that the data block identifiers are unique. Thus, while the absence of a matching data block identifier surely identifies the data block as not being redundant, a matching data block identifier may not necessarily identify the data block as being redundant, as two data blocks having different data may lead to the same data block identifier.

Therefore, if in operation 603 the decision is "YES", indicating that a matching data block identifier was obtained in operation 602, a redundancy determination on a second determination level is performed in an operation 604. The operation 604 may be similar to the operation 602, however, will include the computation of a more detailed data block identifier or other identifier for better identifying a corresponding data block.

As in practical applications possibly only few number of "YES" results will be obtained in operation 603, the higher complexity operation 604 need not be executed frequently. Operation 604 may correspond for example to the operations 201, 202 of Fig. 2a, 251, 252 of Fig. 2b and 402, 403 of Fig. 4.

In an operation 605 it is identified whether a matching data block identifier was found in operation 604. If in operation 605 the decision is "YES", indicating that a matching data block identifier was identified, the flow of operation proceeds to a third determination level redundancy check of an operation 606.

Operation 606 may be similar to the operation 604, however, again involving the computation of another again more detailed data block identifier for the data block. If the third determination level, as in Fig. 6 exemplarily shown, is the last determination level, this operation may preferably include a bit by bit comparison of the corresponding data blocks.

In operation 607 it is determined whether the data block identifiers or bit by bit comparison indicates redundancy of the considered data block. Thus, if in operation 607 the decision is "YES", indicating redundancy, the data block is registered as being redundant in an operation 608, for example as outlined with respect to previous embodiments.

Further, if in operation 603, 605 and 607 the decision is "NO", indicating that the data block is not redundant, the data block is registered in an operation 609 as not being redundant, for example as outlined with respect to previous embodiments.

If the data block is determined to be not redundant in the operation 603, 605 and 607, the correspondingly computed data block identifiers or identifiers may be stored in respective lists of data block identifiers of the respective determination level. Thus, for each determination level a list of data block identifiers may be maintained, e.g. with associated identifiers of corresponding data blocks, in order to facilitate the redundancy check on the respective levels.

The embodiment described with respect to Fig. 6 allows to reduce an overall processing requirement, as computationally more complex redundancy checks are only performed if a corresponding lower determination level indicates a quality of the data block identifiers.

In the following a further embodiment of the invention will be described with respect to Fig. 7.

Fig. 7 shows elements of a system for eliminating data redundancies according to another embodiment of the invention. Fig. 7 particularly illustrates an example of a distributed system employing the features of the invention. A plurality of application programs or processes, wishing to allocate memory space for data blocks, perform a registration operation using a registration handler in order to avoid multiple memory allocations for identical data blocks.

Fig. 7 illustrates a first application unit 70 including a first process 71. Further, Fig. 7 illustrates a second application unit including a second process 73.

Further, Fig. 7 shows storage means 78, e.g. constituted by a storage means shared by the first and second application units, as indicated by arrows 700 and 701.

Still further, Fig. 7 shows a registration handler 74, including a registration unit 75, determining unit 76, a list of data block identifiers 77 and a identifier obtaining unit 79. The registration handler 74 may have a similar functionality as the apparatus for eliminating data redundancies 10 described in Fig. 1 and 3.

In the following, the elements of the system for eliminating data redundancies shown in Fig. 7 will be described in further detail. It is noted that the following details are examples only and that the invention is not limited to the exact features given below.

The first application unit 70 may for example be a general purpose data processing unit executing an application programme for providing a service to a user, e.g. a user operating the data processing unit.

Similarly, the second application unit 72 may be a general purpose data processing device for executing an application programme for providing a service to a user operating the data processing device. While in the shown embodiment the first and second application units 70 and 72 are separate units, it is also possible that the units are formed by a single device, such as a single general purpose data processing unit or similar. Also, while the first and second application units 70 and 72 may execute different application programmes, it is also possible that the application units execute the same application programme or execute different modules of a single application programme.

The first application unit 70 includes a first process 71, for example a process in accordance with the application programme or application module, running on a central processing unit of the first application unit 70.

Similarly, the second application unit 72 includes a second process 73, which may be a process in connection with an application programme or application module executed at the second application unit 72.

If the first and second application units 70 and 72 form a single device, the first process 71 and the second process 73 may be processes in connection with a single application programme or application module.

The first and second process may provide services to users operating the corresponding application unit, for example, in connection with editing a document, retrieving data, playback of video information, mathematical computations or similar, as outlined previously.

The storage means 78 may be a separate storage device, such as a data base, may be a random access memory, a hard disc, a read- and writeable compact disc or similar. The storage means 78 may be connected to the first process 71 and the second process 73 via external communication links, for example, including a network, dedicated communication links including wireless communications.

Further, if the first application unit and the second application unit 70 and 72 constitute a single device, the storage means 78 may form a random access memory of the common device, a hard disc or similar.

The identifier obtaining unit 79, the registering unit 75, the determining unit 76 and the list of data block identifiers 77 may correspond to the corresponding units described with respect to Figs. 1 and 3, and a detailed description is not repeated at this place.

The registration handler 74 functions as a central broker for allocation requests for memory space for data blocks received from the first application unit 70 and second application unit 72, as indicated by arrows 703 and 705.

The application units or the first and second process 71 and 73 may generate such an allocation request, if the respective process needs a memory allocation for a certain data block, for example on a hard disc, a random access memory or similar.

In this case, the process will transmit an allocation request to the registration handler 74, the allocation request at least identifying the data block to be considered. The allocation request could also include the entire data block to be registered.

Based on the allocation request, the registration handler 74, e.g. using the identifier obtaining unit 79, computes a data block identifier for the corresponding data block, e.g. after receiving the data block with the allocation request or retrieving the data block upon receiving an identifier of the data block with the allocation request from the process.

The data block identifier computation may be performed as outlined with respect to previous embodiments.

Upon obtaining the data block identifier, the determining unit 76 may determine whether a data block identifier is already available at the registration handler, for example in the list of data block identifiers 77, or at any other location. Again, the corresponding operations may be as outlined with respect to previous embodiments.

In dependence on the determination result, i.e. if it is determined that the data block to be registered is redundant or not redundant, the registration handler 74 will preferably generate an allocation message and transmit same to the requesting process, as indicated by arrow 704 for the first application unit 70 and arrow 706 for the second application unit 72.

The allocation message, if the data block is determined to be not redundant, may include an instruction to allocate corresponding storage space in the storage means 78. Further, if it is determined that the data block is redundant, the allocation message may include a link to another storage location already storing the information of the first data block, as for example with respect to previous embodiments.

In the above described example, the identifier obtaining unit 79 is located at the registration handler 74, however, in alternative embodiments the identifier obtaining unit 79 may be located at the first application unit 70 and the second application unit 72. In this case, the data block identifier for a data block to be registered is directly calculated at the respective application unit and the allocation request as transmitted from the first and second application units 70 and 72 to the registration handler 74 may include the data block identifier computed at the respective application unit.

The embodiment described with respect to Fig. 7 allows a plurality of processes, for example of one or different application programmes or application modules to jointly use memory allocations for data, thus eliminating data redundancies.

For example, if the first application unit 70 and second application unit 72 is constituted by a server unit being in communication with a plurality of client units, the client units could individually launch service applications in order to establish respective communication sessions between the server unit and each client unit.

In the prior art, in this case identical memory allocations would be carried out for each communication session, thus requiring potentially large data memories, such as random access memories, hard discs or similar. According to the invention, multiple allocations for the same data blocks may be avoided, as each process first registers the data block to be allocated for, and only if the data block is not already registered, the process proceeds to allocate storage space for the data block. If the data block is already registered, i.e. already available in the storage means, e.g. storage means 78, the registration handler 74 only returns a link to the storage location storing the data block to the process, and thus the process may avoid allocating further storage space for the data block and instead use the link for accessing the corresponding information of the data block.

Thus, the registration handler may include a identifier obtaining unit to calculate a first data block identifier for a first data block, or may receive a data block identifier of a data block with an allocation request. Further, the registration handler 74 may include a determining unit to determine further a second data block identifier for a second data block matching the first data block identifier is available in a list of data block identifiers including a plurality of data block identifiers, and a registering unit may be provided to register the first data block in accordance with the determination result, as outline before.

The registering unit may be adapted to add the first data block identifier to the list of data block identifiers, in case the second data block identifier is not available and, may be adapted to store an identifier of the first data block in association with the first data block identifier.

The first and second application units may adapted to generate a memory allocation request for a first data block, the allocation request including a data block identifier of the data block to be registered, an identifier of the data block or the data block itself. In dependence on the determining operation at the redundancy handler, the application unit then receives an allocation response at least indicating whether the second data block identifier of the second data block is available. In dependence thereon, the application unit may allocate memory space or use for example a link to another memory allocation for further processing.

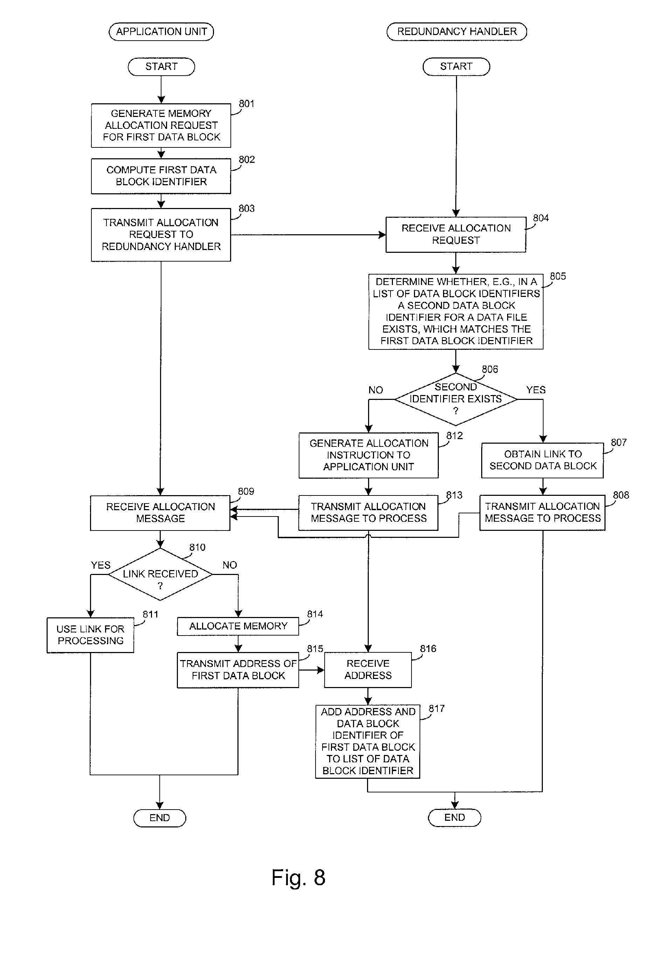

In the following, a further embodiment of the invention will be described with respect to Fig. 8.

Fig. 8 illustrates operations of a message for eliminating data redundancies according to another embodiment of the invention. The operations of Fig. 8 may be carried out using the system shown in Fig. 7, however, Fig. 8 is not delimited thereto.

On the left-hand side of Fig. 8 operations carried out at an application unit are illustrated, and on the right-hand side of Fig. 8 operations at a redundancy handler are illustrated, for example redundancy handler 74 of Fig. 7.

In a first operation 801 a memory allocation for a first data block is generated at the application unit, e.g., by a process running at a data processing unit of the application unit. The allocation request may be generated during providing service to a user and may concern any type of data, as outlined before.

In an operation 802 a first data block identifier, e.g. a checksum, for the first data block is calculated at the application unit, for example as outlined with respect to previous embodiments.

In an operation 803 the allocation request is transmitted to the redundancy handler, for example redundancy handler 74 of Fig. 7, where it is received in an operation 804. The transmission of the allocation request may be performed using any type of communication link, including internal connections, local area networks or wide area networks, dedicated communication links, wireless transmissions, and similar.

In an operation 805 at the redundancy handler it is determined whether a second data block identifier for a second data block exists which matches the first data block identifier. This operation may be similar to what was outlined with respect to previous embodiments.

In an operation 806 it is decided whether the second data block identifier exists. If in operation 806 the decision is "Yes", indicating that the second data block identifier exists, and that consequently the data block subject of the allocation request is redundant, in an operation 807 the redundancy handler determines a link to a data block associated with the second data block identifier. The link may be a pointer to a memory partition, e.g. in the memory 78 of Fig. 7, storing data of the data block associated with the second data block identifier, i.e., data identical to the data of the data block subject of the allocation request.

In an operation 808 the redundancy then generates an allocation message for transmission to the application unit, at least including the link. The allocation message may be transmitted as outlined with respect to operations 803 and 804.

In an operation 809 at the application unit, the allocation message is received and analysed to determine its content.

In an operation 810 at the application unit it is decided whether the analysis of operation 809 indicated that a link was received. If the decision in operation 810 is "Yes", in an operation 813 the link received with the allocation message is used for further processing, for example accessing the corresponding data for following processing operations. Since the link preferably points to a memory location storing data identical to the data block subject of the allocation request, the application unit may readily continue normal processing.

Further, if in operation 806 the decision is "No", indicating that the second data block identifier does not exist, i.e. that the data block not redundant, in an operation 812 an allocation instruction for the application unit is generated.

The allocation instruction at least includes information instructing the application unit or process to perform an allocation operation for the subject data block.

The allocation instruction is transmitted to the application unit in an operation 813, e.g., as the allocation request in operations 803 and 804.

The allocation message now includes the allocation instruction (as opposed to the link of operation 808) and therefore, the decision in operation 812 will be "No", indicating that an allocation instruction was received at the application unit.

Consequently, in an operation 814 the application unit proceeds to allocate memory space for the data block, for example in the storage means 78 of Fig. 7.

Subsequently, in an operation 815 the application unit obtains an address of the memory partition for the data block allocated in operation 814 and transmits same to the redundancy handler, in order to make the allocated memory space storing the data block available to other application units or processes.

The address is received at the redundancy handler in an operation 816 and, in an operation 817 the redundancy handler adds the address and the data block identifier of the first data block to a list of data block identifiers.

Thus, the redundancy handler maintains an up-to-date list of registered data blocks, such that memory space is not allocated twice for the same data block.

It is noted that the redundancy handler may be connected to a plurality of application units, as outlined before, such that a plurality of application programmes, processes or application modules may access and utilize the same memory partitions storing respective data blocks needed for respective processing operations.

While the operations of Fig. 8 are shown in a specific sequence, it is noted that further embodiments may have, within reason, different sequences of operations.

Further, operation 802, including the computation of the first data block identifier may, in an alternative embodiment, be performed at the redundancy handler, e.g., after receiving an allocation request including an identifier of the data block or the data block itself. In this case, preferably the allocation request includes an address of a memory or a source for obtaining the data block for the computation of the data block identifier, or the allocation request may directly include the data block.

It is noted that the multi-level redundancy check particularly outlined with respect to Figs. 5 and 6 may be used in combination with any of the other embodiments, particularly the embodiments of Figs. 7 and 8.

It further noted that a computer-readable medium may be provided having a programme recorded thereon, where the programme is to make a computer or system of data processing devices execute functions of the features and elements of the above described embodiments of Figs. 1 - 8. A computer-readable medium can be a magnetic or optical or other tangible medium on which a programme is recorded, but can also be a signal, e.g., analogue or digital, electromagnetic or optical, in which the programme is embodied for transmission.

Further, a computer programme product may be provided comprising the computer-readable medium.

In the following, a further embodiment of the invention will be described. An apparatus for eliminating data redundancies may be embodied as follows:
1). Apparatus for eliminating data redundancies, comprising:
   a code section containing instructions to obtain a first data block identifier for a first data block, the first data block identifier being calculated based on the data of the first data block;
   a code section containing instructions to determine whether a second data block identifier matching the first data block identifier is available, the second data block identifier being calculated based on the data of the second data block; and
   a code section containing instructions to register the first data block in accordance with the determination result.
2). Apparatus of 1), including a code section containing instructions to add the first data block identifier to a list of data block identifiers, in case the second data block identifier is not available.
3). Apparatus of 1), including a code section containing instructions to store an identifier of the first data block in association with the first data block identifier.
4). Apparatus of 1), including a code section containing instructions to, in case the second data block identifier is available, one of the group consisting of:
   - delete the first data block from a storage means; and
   - replace the first data block in a storage means by a link to the second data block, in case the second data block identifier is available.
5). Apparatus of 1), including a code section containing instructions to, in case the second data block identifier is not available, at least one of the group consisting of:
   - store the first data block on a data carrier; and
   - transmit the first data block to a receiving unit.
6). Apparatus of 1), including
   including a code section containing instructions to receive a memory allocation request for the first data block from a process;
   including a code section containing instructions to, in case the second data block identifier is available, generate and transmit a link to the data block to the process; and
   including a code section containing instructions to, in case the second data block identifier is not available, transmit an allocation instruction to the process to instruct the process to allocate storage space for the first data block, receive an address of the allocated storage space and include the address into the list of data block identifiers.
7). Apparatus of 1), wherein the first and second data block identifiers are constituted by checksums.
8). Apparatus of 1), including a code section containing instructions to, in case the second data block identifier is available,
   retrieve a second data block associated with the second data block identifier; and
   perform a processing operation for determining whether the first data block and the second data block correspond to one another.
9). Apparatus of 1), wherein the processing operation includes at least one of the group consisting of:
   - computing data block identifiers of the first data block and the second data block having more bits than the first and second data block identifier;
   - comparing the bits of the first data block and the second data block.
10). Apparatus of 1), including a code section containing instructions to compare at least one of
   - data block names of the first and second data block;
   - dates indicating a time of creation of the first and second data block; and
   - dates indicating a time of alteration of the first and second data block.
   Further, an application unit for avoiding data redundancies may be embodied as follows:
11). Application unit for avoiding data redundancies, including
   a code section containing instructions to obtain a first data block identifier for a first data block, the first data block identifier being calculated based on the data of the first data block;
   a code section containing instructions to generate a memory allocation request for the first data block;
   a code section containing instructions to transmit the memory allocation request to a redundancy handler, instructing the redundancy handler to determine whether a second data block identifier for a second data block matching the first data block identifier is available, the second data block identifier being calculated based on the data of the second data block; and
   a code section containing instructions to receive an allocation response at least indicating whether the second data block identifier of the second data block is available.
12). Application unit of 11), wherein the allocation request includes at least one of an identifier of the first data block and the first data block identifier.
13). Application unit of 11), including a code section containing instructions to, in case the second data block identifier is available, use a link to the second data block included in the allocation response to access the second data block.
14). Application unit of 11), including a code section containing instructions to, in case the second data block identifier is not available, allocate storage space for the first data block in response to receiving an allocation instruction included in the allocation response, and to transmit an address of the allocated storage space to the redundancy handler, instructing the redundancy handler to store the address of the first data block in association with the first data block identifier.
15). Application unit of 11), wherein the first and second data block identifiers are constituted by checksums.
16). Application unit of 11), including a code section containing instructions to, in case the second data block identifier is available,
   retrieve a second data block associated with the second data block identifier; and
   perform a processing operation for determining whether the first data block and the second data block correspond to one another.
17). Application unit of 16), wherein the processing operation includes at least one of the group consisting of:
   - computing data block identifiers of the first data block and the second data block having more bits than the first and second data block identifier;
   - comparing the bits of the first data block and the second data block.
18). Application unit of 16), wherein the processing operation includes comparing at least one of
   - data block names of the first and second data block;
   - dates indicating a time of creation of the first and second data block; and
   - dates indicating a time of alteration of the first and second data block.

## Claims

1. Method for eliminating data redundancies, comprising:
obtaining a first data block identifier for a first data block, the first data block identifier being calculated based on the data of the first data block;
determining whether a second data block identifier matching the first data block identifier is available, the second data block identifier being calculated based on the data of the second data block; and
registering the first data block in accordance with the determination result.

2. Method of claim 1, including adding the first data block identifier to a list of data block identifiers, in case the second data block identifier is not available.

3. Method of one of the preceding claims, wherein adding the first data block identifier to the list of data block identifier includes storing an address of the first data block in association with the first data block identifier.

4. Method of one of the preceding claims, wherein registering the first data block, in case the second data block identifier is available, includes one of the group consisting of:
- deleting the first data block from a storage means; and
- replacing the first data block in a storage means by a link to the second data block.

5. Method of one of the preceding claims, wherein registering the first data block, in case the second data block identifier is not available, includes at least one of the group consisting of:
- storing the first data block on a data carrier; and
- transmitting the first data block to a receiving unit.

6. Method of one of the claims 1 - 3, including
receiving a memory allocation request for the first data block from a process;
wherein registering the first data block includes, in case the second data block identifier is available, generating and transmitting a link to the data block to the process; and
wherein registering the first data block includes, in case the second data block identifier is not available, transmitting an allocation instruction to the process to instruct the process to allocate storage space for the first data block, receiving an address of the allocated storage space and including the address into the list of data block identifiers.

7. Method of one of the preceding claims, wherein the first and second data block identifiers are constituted by checksums.

8. Method of one of the preceding claims, including, in case the second data block identifier is available, retrieving a second data block associated with the second data block identifier; and
performing a processing operation for determining whether the first data block and the second data block correspond to one another.

9. Method of one of claim 8, wherein the processing operation includes at least one of the group consisting of:
- obtaining detailed data block identifiers of the first data block and the second data block having more bits than the first and second data block identifier; and
- comparing the bits of the first data block and the second data block.

10. Method of one of the claims 8 or 9, wherein the processing operation includes comparing at least one of
- data block names of the first and second data block;
- dates indicating a time of creation of the first and second data block; and
- dates indicating a time of alteration of the first and second data block.

11. Method for avoiding data redundancies at a data processing unit, including
obtaining a first data block identifier for a first data block, the first data block identifier being calculated based on the data of the first data block;
generating a memory allocation request for the first data block at the data processing unit;
transmitting the memory allocation request to a redundancy handler, instructing the redundancy handler to determine whether a second data block identifier matching the first data block identifier is available, wherein the second data block identifier is calculated based on the data of the second data block; and
receiving an allocation response at least indicating whether the second data block identifier of the second data block is available.

12. Method of claim 11, wherein
the allocation request includes at least one of an address of the first data block and the first data block identifier; and
in case the second data block identifier is available, the allocation response includes a link to the second data block and wherein the data processing unit uses the link to the second data block to access the second data block.

13. Method of one of the claims 11 or 12, wherein, in case the second data block identifier is not available, the allocation response includes an allocation instruction to allocate storage space for the first data block, and to transmit an address of the allocated storage space to the redundancy handler, instructing the redundancy handler to store the address of the first data block in association with the first data block identifier in a list of data block identifiers.

14. Method of one of the claim 11- 13, wherein the first and second data block identifiers are constituted by checksums.

15. Method of one of the claims 11 - 14, including, in case the second data block identifier is available,
retrieving a second data block associated with the second data block identifier; and
performing a processing operation for determining whether the first data block and the second data block correspond to one another.

16. Method of claim 15, wherein the processing operation includes at least one of the group consisting of:
- computing detailed data block identifiers of the first data block and the second data block having more bits than the first and second data block identifier;
- comparing the bits of the first data block and the second data block.

17. Method of one of the claims 15 or 16, wherein the processing operation includes comparing at least one of
- data block names of the first and second data block;
- dates indicating a time of creation of the first and second data block; and
- dates indicating a time of alteration of the first and second data block.

18. A program having instructions adapted to carry out the method of one of the preceding claims.

19. A computer readable medium, in which a program is embodied, where the program is to make a computer execute the method of one of the claims 1 - 17.

20. A computer program product comprising the computer readable medium according to claim 19.

21. Apparatus for eliminating data redundancies, comprising:
a identifier obtaining unit to obtain a first data block identifier for a first data block, the first data block identifier being calculated based on the data of the first data block;
a determining unit to determine whether a second data block identifier matching the first data block identifier is available, the second data block identifier being calculated based on the data of the second data block; and
a registering unit to register the first data block in accordance with the determination result.

22. Apparatus of claim 21, wherein the registering unit is adapted to add the first data block identifier to a list of data block identifiers, in case the second data block identifier is not available.

23. Apparatus of one of the claims 21 or 22, wherein the registering unit is adapted to store an identifier of the first data block in association with the first data block identifier.

24. Apparatus of one of the claims 21 - 23, wherein the registering unit is adapted to, in case the second data block identifier is available, one of the group consisting of:
- delete the first data block from a storage means; and
- replace the first data block in a storage means by a link to the second data block, in case the second data block identifier is available.

25. Apparatus of one of the claims 21 - 24, wherein the registering unit is adapted, in case the second data block identifier is not available, to at least one of the group consisting of:
- store the first data block on a data carrier; and
- transmit the first data block to a receiving unit.

26. Apparatus of one of the claims 21 - 25, including
means for receiving a memory allocation request for the first data block from a process;
wherein the registering unit is adapted to, in case the second data block identifier is available, generate and transmit a link to the data block to the process; and
wherein the registering unit is adapted to, in case the second data block identifier is not available, transmit an allocation instruction to the process to instruct the process to allocate storage space for the first data block, receive an address of the allocated storage space and include the address into the list of data block identifiers.

27. Apparatus of one of the claims 21 - 26, wherein the first and second data block identifiers are constituted by checksums.

28. Apparatus of one of the claims 21 - 27, wherein the determining unit is adapted to, in case the second data block identifier is available,
retrieve a second data block associated with the second data block identifier; and
perform a processing operation for determining whether the first data block and the second data block correspond to one another.

29. Apparatus of one of the claims 21 - 28, wherein the processing operation includes at least one of the group consisting of:
- computing data block identifiers of the first data block and the second data block having more bits than the first and second data block identifier;
- comparing the bits of the first data block and the second data block.

30. Apparatus of one of the claims 21 - 29, wherein the determining unit is adapted to compare at least one of
- data block names of the first and second data block;
- dates indicating a time of creation of the first and second data block; and
- dates indicating a time of alteration of the first and second data block.

31. Application unit for avoiding data redundancies, adapted to
obtain a first data block identifier for a first data block, the first data block identifier being calculated based on the data of the first data block;
generate a memory allocation request for the first data block;
transmit the memory allocation request to a redundancy handler, instructing the redundancy handler to determine whether a second data block identifier matching the first data block identifier is available, the second data block identifier being calculated based on the data of the second data block; and
receive an allocation response at least indicating whether the second data block identifier of the second data block is available.

32. Application unit of claim 31, wherein the allocation request includes at least one of an identifier of the first data block and the first data block identifier.

33. Application unit of one of the claims 31 or 32, adapted to, in case the second data block identifier is available, to use a link to the second data block included in the allocation response to access the second data block.

34. Application unit of one of the claims 31 - 33, adapted to, in case the second data block identifier is not available, allocate storage space for the first data block in response to receiving an allocation instruction included in the allocation response, and to transmit an address of the allocated storage space to the redundancy handler, instructing the redundancy handler to store the address of the first data block in association with the first data block identifier.

35. Application unit of one of the claims 31 - 34, wherein the first and second data block identifiers are constituted by checksums.

36. Application unit of claim 31 - 35, adapted to, in case the second data block identifier is available,
retrieve a second data block associated with the second data block identifier; and
perform a processing operation for determining whether the first data block and the second data block correspond to one another.

37. Application unit of claim 36, wherein the processing operation includes at least one of the group consisting of:
- computing data block identifiers of the first data block and the second data block having more bits than the first and second data block identifier;
- comparing the bits of the first data block and the second data block.

38. Application unit of one of the claims 36 or 37, wherein the processing operation includes comparing at least one of
- data block names of the first and second data block;
- dates indicating a time of creation of the first and second data block; and
- dates indicating a time of alteration of the first and second data block.
